# EUROPEAN PATENT SPECIFICATION

(11) **EP 2 941 111 B1**
(45) Date of publication and mention of the grant of the patent: **08.03.2017**
(21) Application number: 12890647.6
(22) Date of filing: 27.12.2012
(51) Int. Cl.: H05K 13/02, B65H 21/00, B65H 20/20

(54) **SPLICING DEVICE AND SPLICING-TAPE DETECTION METHOD**
SPLEISSVORRICHTUNG UND SPLEISSBANDERKENNUNGSVERFAHREN
DISPOSITIF D'ÉPISSAGE,ET PROCÉDÉ DE DÉTECTION DE RUBANS D'ÉPISSAGE

(43) Date of publication of application: 04.11.2015
(73) Proprietor: Fuji Machine Mfg. Co., Ltd., Chiryu-shi Aichi 472-8686 (JP)
(72) Inventor: CHI Xiao Dong, Chiryu-shi Aichi 472-8686 (JP)
(74) Representative: Grünecker Patent- und Rechtsanwälte PartG mbB
(86) International application number: PCT/JP2012/083867
(87) International publication number: WO 2014/102965

(56) References cited:
- JP-A- 2000 038 242
- JP-A- 2002 207 286
- JP-A- 2003 031 989
- JP-A- 2010 087 390
- JP-A- 2011 233 600
- JP-A- 2012 169 351
- JP-A- 2012 169 352
- JP-A- 2012 248 592
- US-A1- 2004 039 480

## Description

### Technical Field

The present invention relates to a splicing apparatus which connects two carrier tapes to each other, and a method of detecting a splicing tape that is used in the splicing apparatus.

### Background Art

Generally, in a component mounting machine, a carrier tape which retains a plurality of electronic components at regular intervals is wound around a reel and a sprocket which engages with sprocket holes bored in the carrier tape is driven so as to feed the carrier tape by a regular quantity and to sequentially supply the electronic components to a component supply position, thereby adsorbing the electronic components by a suction nozzle and mounting the electronic components in a circuit board.

In such a type of the component mounting machine, when the remaining quantity of the electronic components retained in one reel decreases, so-called splicing processing for causing a leading end portion of the carrier tape which is wound around another reel retaining the same types of the electronic components to be connected to a trailing end portion of the carrier tape of which the remaining quantity decreases is executed, by the splicing tape. PTL 1 discloses a device which includes such a splicing function.

Furthermore, the prior art in document JP 2000-038242 A (PTL 2) discloses a connection method and a tape for connection. According to PTL 2, the tape for connection is constituted by a basic material tape 2, a connection tape 3 based on a mold release face of the basic material tape 2, and a protection tape 4 which covers the connection tape 3 and is stuck on the basic material tape 2 and the connection tape 3. The connection tape 3 is provided with a first connection tape 31 in which feed holes agreeing with feed holes of taping shaped like square punch carrier are formed at the same feed hole pitch and which can be stuck on a top face of the taping of a square hole punch carrier shape without interfering with a top cover tape, a second connection tape 32 which can be bonded on the top cover tape, and a third connection tape 33 which can be bonded on a bottom cover tape.

### Citation List

### Patent Literature

- PTL 1:: JP-A-2007-335595
- PTL 2:: JP-A-2000-038242

### Summary of Invention

### Technical Problem

Incidentally, in recent years, attempts have been made to perform splicing automatically. However, in order to perform splicing automatically, a splicing tape needs to be automatically conveyed to a splicing position. Generally, the splicing tape is configured to form one set of the splicing tapes including a front face splicing tape for connecting a front face side of a carrier tape and a rear face splicing tape for connecting a rear face side of the carrier tape, and it is important that the front face splicing tape and the rear face splicing tape are accurately positioned at the splicing position so as not to be reversely disposed, when being automated.

An object of the present invention is to provide a splicing apparatus in which the one set of the splicing tapes for a front face and a rear face connecting the two carrier tapes to each other can be accurately positioned at the splicing position, and a method of detecting a splicing tape that is used in the splicing apparatus.

### Solution to Problem

In order to achieve the object described above, according to the invention of Claim 1, there is provided a splicing apparatus in which a first carrier tape and a second carrier tape provided with sprocket holes and component accommodation cavities at regular intervals are connected to each other by a splicing tape. The splicing apparatus includes a positioning device that feeds the first and second carrier tapes in a direction approaching each other and causes positioning pins to be positioned at a splicing position so as to be able to engage with the sprocket holes of the first and second carrier tapes, a plurality of the splicing tapes that are pasted at the splicing position on a continuous protection tape fed in a direction orthogonal to a feeding direction of the first and second carrier tapes and form one set with a front face splicing tape for connecting a front face side of the carrier tape and a rear face splicing tape for connecting a rear face side of the carrier tape, a pair of sensors that is disposed at an interval in the feeding direction of the protection tape and detects the splicing tapes, and a bonding device that bonds the splicing tapes fed to the splicing position onto both faces across the first and second carrier tapes. The splicing tapes are regularly arranged at intervals in a longitudinal direction of the protection tape, and the pair of sensors is configured to be simultaneously turned on only when the one set of the splicing tapes is positioned at the splicing position.

According to the invention of Claim 1, since it is possible to detect that the one set of the splicing tapes for the front face and the rear face is positioned at the splicing position as the pair of sensors is simultaneously turned on, the front face splicing tape and the rear face splicing tape can be accurately positioned at the splicing position so as not to be reversely disposed, and thus, it is possible to acquire the splicing apparatus which can perform highly accurate splicing.

Accordingly, when the protection tape having the splicing tape pasted thereon is set to the splicing apparatus, it is possible to detect that a first splicing tape is accurately positioned at the splicing position, by using the pair of sensors, and it is possible to detect disconnection of the splicing tape based on a state in which the pair of sensors is not simultaneously turned on even though a predetermined quantity of the splicing tapes is fed.

According to the invention of Claim 2, in the splicing apparatus according to Claim 1, metal is embedded in the splicing tape and the sensor is formed to be a metal detection sensor which detects metal.

According to the invention of Claim 2, it is possible to simply and reliably detect the splicing tape by using the metal detection sensor by only embedding metal in the splicing tape.

According to the invention of Claim 3, in the splicing apparatus according to Claim 1 or 2, the one set of the splicing tapes is positioned at positions where the pair of sensors is simultaneously turned on by forming feeding holes at both ends of the protection tape in a width direction and rotating a sprocket which engages with the holes so as to feed the protection tape N times by a unit quantity.

According to the invention of Claim 3, since feeding accuracy of the protection tape can be enhanced based on a rotation amount of the sprocket, it is possible to accurately position the splicing tape at the splicing position regardless of slackness and the like of the protection tape.

According to the invention of Claim 4, there is provided a method of detecting a splicing tape that is used in a splicing apparatus in which a first carrier tape and a second carrier tape provided with sprocket holes and component accommodation cavities at regular intervals are connected to each other by the splicing tape. One set of the splicing tapes for the front face and the rear face which is glued onto both faces across the first and second carrier tapes positioned at a splicing position are pasted on a protection tape, and a pair of sensors which is disposed at intervals in a feeding direction of the protection tape is simultaneously turned on only when the one set of the splicing tapes is positioned at the splicing position.

According to the invention of Claim 4, since it is possible to detect that the one set of the splicing tapes for the front face and the rear face is positioned at the splicing position as the pair of sensors is simultaneously turned on, it is possible to acquire a splicing tape detection method in which the front face splicing tape and the rear face splicing tape can be accurately positioned at the splicing position so as not to be reversely disposed.

Accordingly, similarly to the invention of Claim 1, when the protection tape having the splicing tape pasted thereon is set to the splicing apparatus, it is possible to detect that the first splicing tape is accurately positioned at the splicing position, by using the pair of sensors, and it is possible to detect disconnection of the splicing tape based on a state in which the pair of sensors is not simultaneously turned on even though a predetermined quantity of the splicing tapes is fed.

### Brief Description of Drawings

[Fig. 1] Fig. 1 is a diagram illustrating a tape feeder which is suitable for executing the present invention.
[Fig. 2] Fig. 2 is a diagram illustrating a carrier tape which is retained in the tape feeder.
[Fig. 3] Fig. 3 is a cross-sectional view taken along line 3-3 in Fig. 2.
[Fig. 4] Fig. 4(A) is a plan view of the carrier tape which is connected by a splicing apparatus, and Fig. 4(B) is a diagram of the carrier tape which is seen from the side.
[Fig. 5] Fig. 5 is a diagram illustrating an embossed tape.
[Fig. 6] Fig. 6 is a perspective view illustrating the entirety of the splicing apparatus showing an embodiment of the present invention.
[Fig. 7] Fig. 7 is a diagram illustrating a state where a lid body of the splicing apparatus is open.
[Fig. 8] Fig. 8 is a diagram illustrating a state where a splicing tape is mounted in the splicing apparatus.
[Fig. 9] Fig. 9 is a diagram illustrating a supply reel around which the splicing tape used in the splicing apparatus is wound.
[Fig. 10] Fig. 10 is a diagram illustrating a state of the splicing tape which is pasted on a protection tape.
[Fig. 11] Fig. 11 is a view seen in an arrow-11 direction of Fig. 10.
[Fig. 12] Fig. 12 is a diagram illustrating a protection tape feeding device which feeds the protection tape.
[Fig. 13] Figs. 13(A) to 13(F) are explanatory diagrams of operations illustrating relationships between the splicing tape and a pair of sensors when the splicing tape is fed by a regular quantity.
[Fig. 14] Fig. 14 is a diagram illustrating a state where a casing and the lid body of the splicing apparatus are detached so as to expose the inside thereof.
[Fig. 15] Fig. 15 is a diagram illustrating a schematic configuration of the splicing apparatus.
[Fig. 16] Fig. 16 is a diagram of an actuation state of that in Fig. 15 illustrating a step of positioning a cutting place of the carrier tape.
[Fig. 17] Fig. 17 is a diagram of another actuation state of that in Fig. 15 illustrating a step of cutting the carrier tape at the cutting place.

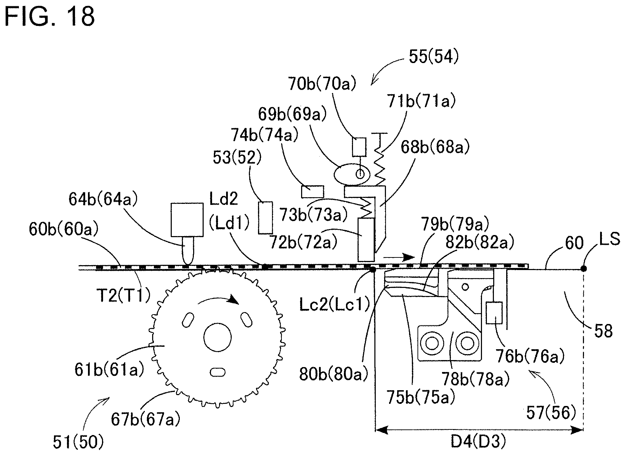

[Fig. 18] Fig. 18 is a diagram of another actuation state of that in Fig. 15 illustrating a step of positioning the carrier tape with respect to a splicing position.
[Fig. 19] Fig. 19 is a perspective view illustrating a bonding device of the splicing apparatus.
[Fig. 20] Fig. 20 is a plan view illustrating the bonding device.
[Fig. 21] Fig. 21 is a front view seen in an arrow-21 direction of Fig. 20.
[Fig. 22] Fig. 22 is a right-side view seen in an arrow-22 direction of Fig. 20.
[Fig. 23] Fig. 23 is a left-side view seen in an arrow-23 direction of Fig. 20.
[Fig. 24] Fig. 24 is a diagram illustrating a locking device for locking the lid body.
[Fig. 25] Fig. 25 is a cross-sectional view illustrating a relationship between the carrier tape and the splicing tape at the splicing position.
[Fig. 26] Figs. 26 (A) to 26 (C) are cross-sectional views taken along line 26-26 in Fig. 25 and illustrate actuation states of splicing.
[Fig. 27] Figs. 27 (A) to 27 (D) are diagrams of actuation states illustrating a step of cutting the embossed tape.

### Description of Embodiment

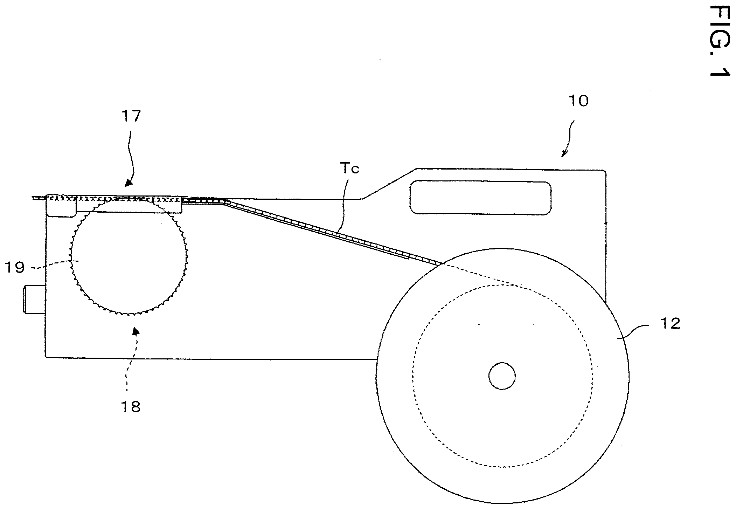

Hereinafter, an embodiment of the present invention will be described with reference to the drawings. Fig. 1 illustrates a tape feeder 10 which is detachably mounted in a component supply device of a component mounting machine. A reel 12 having a carrier tape Tc wound therearound is detachably attached to the tape feeder 10.

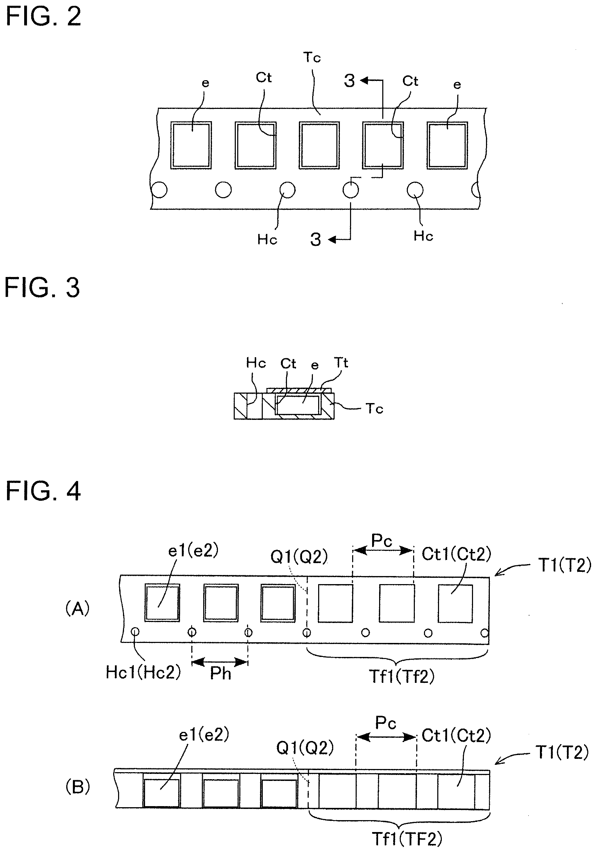

As illustrated in Fig. 2, the carrier tape Tc is formed in an elongated manner having a predetermined width. Multiple cavities Ct are arranged in a longitudinal direction at regular pitch intervals. Components (electronic components) e mounted in a circuit board are respectively accommodated in the cavities Ct. The upper portion of the cavity Ct is open and is covered with a top tape Tt (refer to Fig. 3) which is pasted on the front face of the carrier tape Tc.

On one end side of the carrier tape Tc in a width direction, sprocket holes Hc are formed at the same pitch intervals as those of the cavities Ct or at pitch intervals twice those of the cavities Ct. The sprocket holes Hc are disposed in regular positional relationships with respect to the cavities Ct.

The tape feeder 10 is internally equipped with a quantitative feeding mechanism 18 quantitatively feeding the carrier tape Tc which is wound around the reel 12 and supplying the electronic components e one by one to component supply positions 17 which is provided at the distal end portion of the tape feeder 10. The quantitative feeding mechanism 18 includes a sprocket 19 which is rotatably supported by a main body of the tape feeder 10 and engages with the sprocket holes Hc of the carrier tape Tc, and a motor (not illustrated) for rotating the sprocket 19 by 1 pitch.

The carrier tapes Tc used in the component mounting machine are configured to be in multiple types having the pitch of the cavities Ct different from one another. Depending on the type of the carrier tape Tc, the pitch interval of the cavities Ct and the relationship between the cavity Ct and the sprocket hole Hc are determined. Therefore, as the pitch interval of the cavities Ct is recognized through image processing and the like, it is possible to know the type of the carrier tape Tc. On the basis thereof, the position of the sprocket hole Hc of the carrier tape Tc can be recognized, and thus, a cutting position of the carrier tape Tc at the time of the below-described splicing can be decided.

A splicing apparatus 20 is an apparatus which automatically connects a trailing end portion of a carrier tape wound around an existing reel mounted in the tape feeder 10 that is mounted in the component supply device to a leading end portion of a carrier tape wound around a successive reel replacing the existing reel.

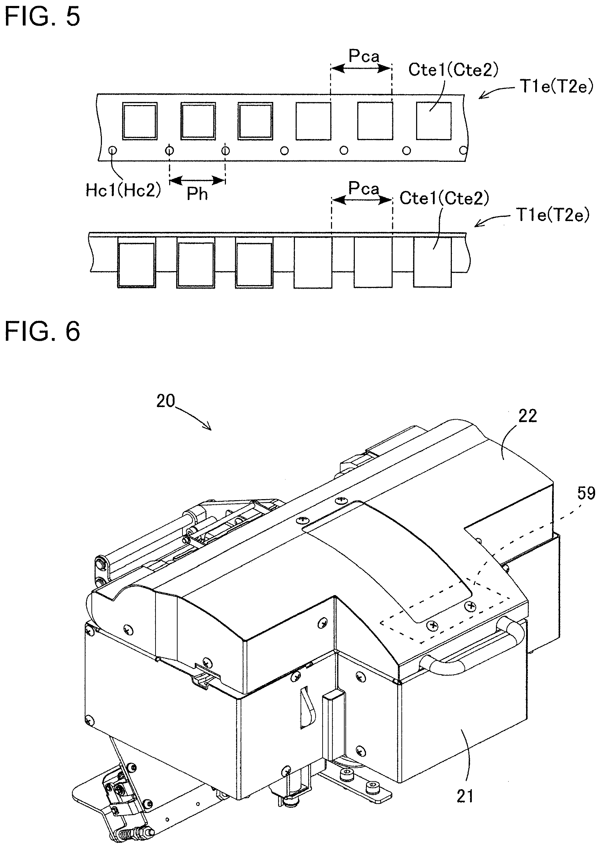

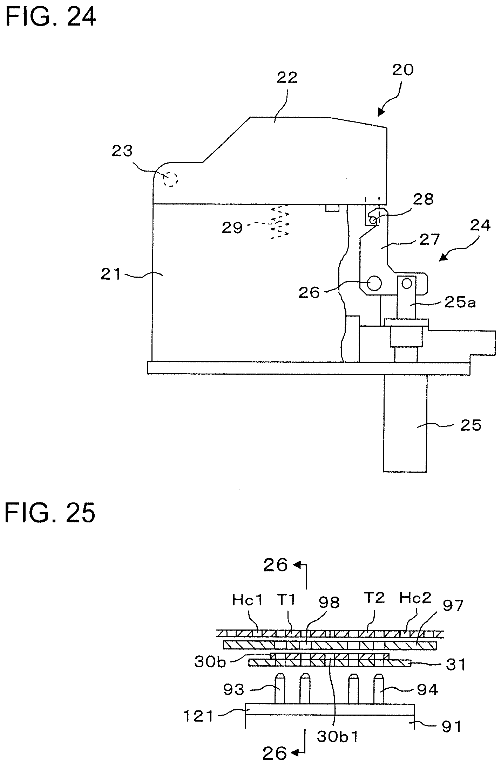

As illustrated in Fig. 6, the splicing apparatus 20 includes a box-like casing 21 and a lid body 22 which is turnably supported by the casing 21 centering around a pivot 23 (refer to Fig. 24) and is used for uncovering and covering the upper face of the casing 21. The splicing apparatus 20 is configured to be loaded on a wheeled table (not illustrated) or the like so as to be movable between the tape feeders 10 mounted in the component supply device of the component mounting machine. The lid body 22 is placed to cover the upper face when performing splicing and is moved to uncover the upper face when taking the carrier tape Tc out after performing splicing. When the lid body 22 covers the upper face once, the closed state is retained by a locking device described below.

In each of two carrier tapes Tc (hereinafter, referred to as a first carrier tape T1 and a second carrier tape T2) which is spliced by the splicing apparatus 20, as illustrated in Fig. 4, first cavities Ct1 (second cavities Ct2) accommodating first components e1 (second components e2) which are the components of the same types are provided at a predetermined pitch Pc.

In each of the first and second carrier tapes T1 and T2, first sprocket holes Hc1 (second sprocket holes Hc2) which can mesh with teeth 67a (67b) of a first sprocket 61a (a second sprocket 61b) in a first tape feeding device 50 (a second tape feeding device 51) described below are bored to be parallel to the first cavities Ct1 (the second cavities Ct2) at a predetermined pitch Ph.

The first and second carrier tapes T1 and T2 are cut at arbitrary first and second cutting places Q1 and Q2 by the splicing apparatus 20, and the cut ends thereof are caused to abut each other, thereby being connected to each other by a splicing tape 30 described below. For example, as the first cutting place Q1 (the second cutting place Q2), an intermediate position between the first cavity Ct1 (the second cavity Ct2) including the first component e1 (the second component e2) and the first vacant cavity Ct1 (the second vacant cavity Ct2) including no first component e1 (no second component e2) is selected.

The first carrier tape T1 (the second carrier tape T2) including the continuous first vacant cavities Ct1 (the continuous second vacant cavities Ct2) after being cut is discarded as a first unnecessary portion Tf1 (a second unnecessary portion Tf2). In order to secure the first vacant cavities Ct1 (the second vacant cavities Ct2) in the arbitrary numbers, an intermediate position between the first vacant cavities Ct1 (the second vacant cavities Ct2) which are adjacent to each other can be selected as the first cutting place Q1 (the second cutting place Q2).

As the carrier tapes T1 and T2, there is an embossed tape T1e (T2e) of which the pitch Pc of the cavities Ct1 (Ct2) are different from each other, or in which the cavities (embossed portions) Cte1 (Cte2) protrude in a thickness direction as illustrated in Fig. 5. The different types of the carrier tapes can also be connected by the splicing apparatus 20.

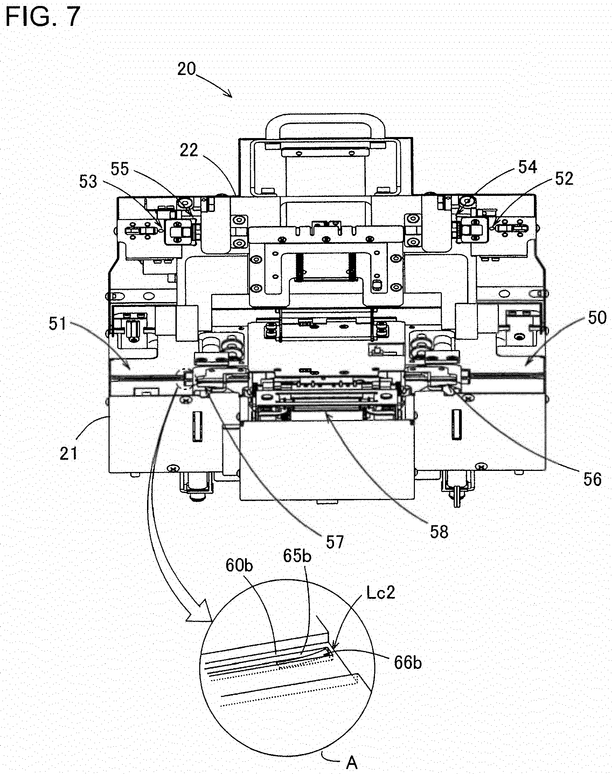

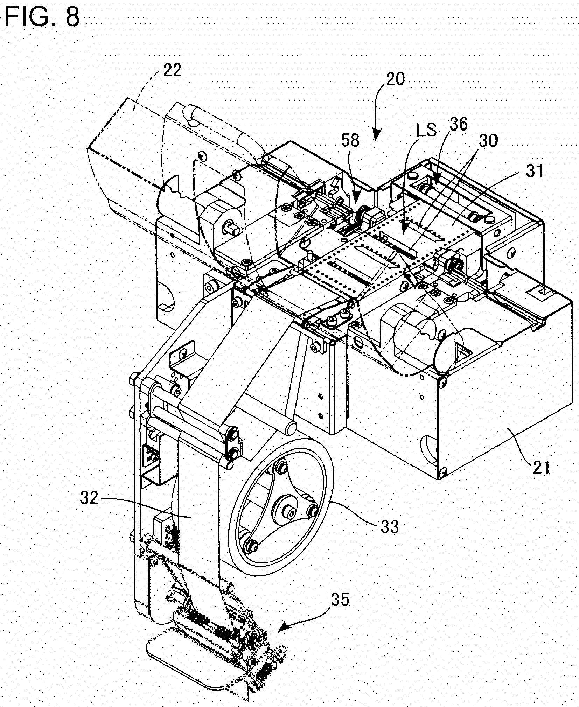

In the splicing apparatus 20, the two carrier tapes T1 and T2 to be spliced are fed from the right and left in Fig. 7, and a protection tape 31 (refer to Fig. 8) having the splicing tape 30 which connects the two carrier tapes T1 and T2 to each other pasted therein is fed from above, that is, orthogonal to the right and left in Fig. 7. Then, as illustrated in Fig. 8, end portions of the two carrier tapes T1 and T2 are connected to each other by the splicing tape 30 at a splicing position LS where the carrier tapes T1 and T2 intersect with the protection tape 31.

The splicing tape 30 pasted on the protection tape 31 is fed into the splicing position LS causing a glue face between the carrier tapes T1 and T2 to face upward, and the two carrier tapes T1 and T2 are positioned above the splicing tape 30.

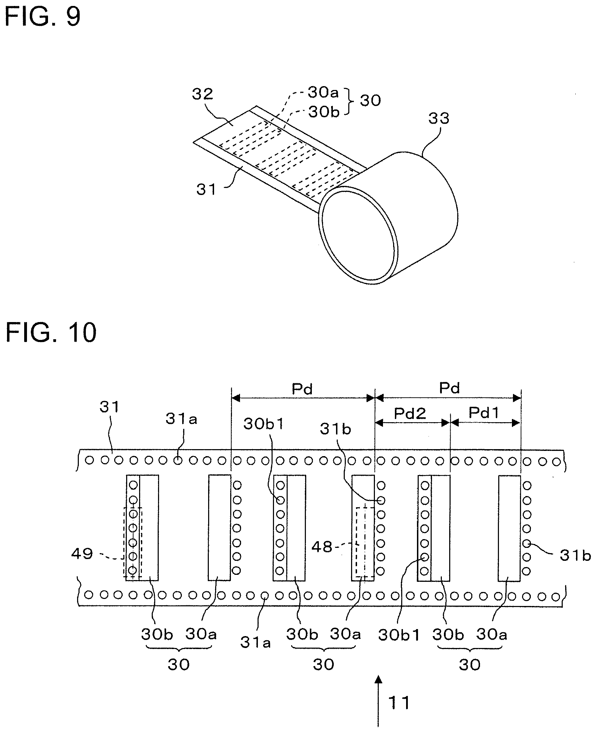

As illustrated in Fig. 10, on the upper face of the continuous protection tape 31, the splicing tape 30 is configured to include one set of splicing tapes 30a and 30b for a front face and a rear face which are glued onto both faces across the two carrier tapes T1 and T2. In other words, the splicing tape 30 is configured to form one set including the front face splicing tape 30a which is bonded onto the front face sides of the two carrier tapes T1 and T2 and the rear face splicing tape 30b which is bonded onto the rear face sides of the two carrier tapes T1 and T2.

The one set of the splicing tapes 30 for the front face and the rear face is pasted on the protection tape 31 in the longitudinal direction at regular pitch intervals Pd while maintaining a regular positional relationship with respect to feeding holes 31a which are bored on both the sides of the protection tape 31 at regular pitch intervals. The one set of the splicing tapes 30a and 30b is disposed at predetermined intervals Pd1 causing the front face splicing tape 30a to be the leading side, and the rear face splicing tape 30b and the successive front face splicing tape 30a are disposed at predetermined intervals Pd2 (Pd2 = Pd - Pd1). Then, metal powder is embedded in the one set of the splicing tapes 30a and 30b so as to be detectable by the below-described metal detection sensors 48 and 49.

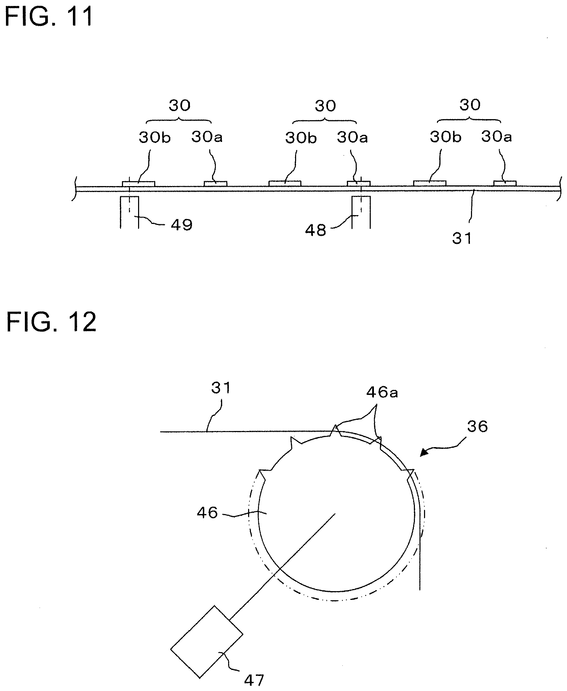

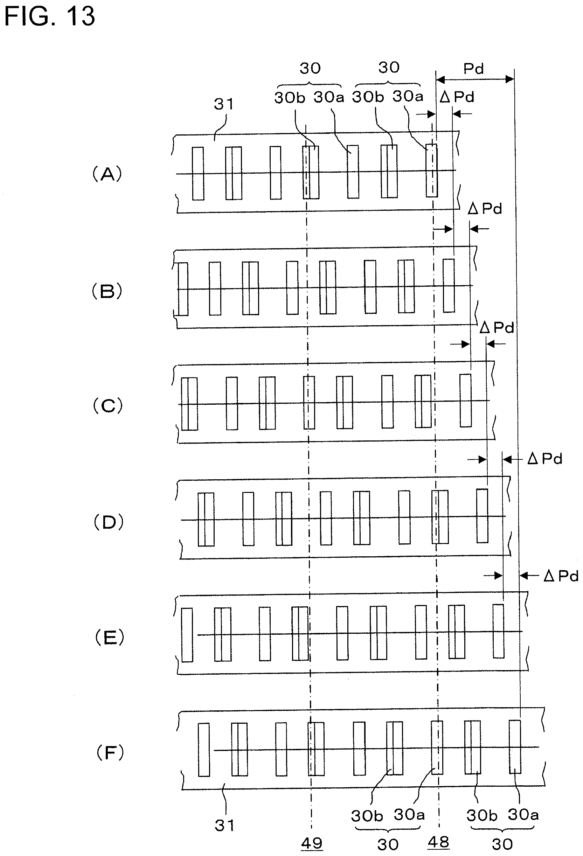

As illustrated in Figs. 10 and 11, two metal detection sensors 48 and 49 which detect the splicing tapes 30a and 30b are disposed below the protection tape 31 at predetermined intervals. Specifically, when the one set of the splicing tapes for the front face and the rear face (first splicing tapes) 30 are positioned at the splicing position LS, the two metal detection sensors 48 and 49 are disposed at positions where the two metal detection sensors 48 and 49 are turned on by the front face splicing tape 30a of the successive one set of the splicing tapes (second splicing tapes) 30 and the rear face splicing tape 30b of the next successive one set of the splicing tapes (third splicing tapes). In states other than those thereof, the two metal detection sensors 48 and 49 are prevented from being simultaneously turned on (refer to Figs. 13(B) to 13(E)).

The upper faces of the splicing tapes 30a and 30b are formed to be adhesive faces which are glued onto both faces across the two carrier tapes T1 and T2. As illustrated in Fig. 9, a continuous paper mount 32 is glued onto the glue face thereof. A three-layer structure body including the paper mount 32, the splicing tape 30, and the protection tape 31 is wound around a supply reel 33 in a rolled manner.

The measurement of the protection tape 31 in the width direction is greater than the measurement of the paper mount 32 in the width direction, and both ends of the protection tape 31 in the width direction protrude further than both ends of the paper mount 32 in the width direction. Meanwhile, the measurement of the splicing tape 30 in the width direction is equivalent to the measurement of the paper mount 32 in the width direction, and the splicing tape 30 is pasted on the protection tape 31 forming one set with the splicing tapes for the front face and the rear face on the inner side of the feeding hole 31a.

As illustrated in Fig. 10, a plurality of positioning holes 31b are formed in the protection tape 31 along the protection tape 31 in the width direction at the same pitch intervals as those of the sprocket holes Hc1 and Hc2 which are formed in the carrier tapes T1 and T2 at a position near the front face splicing tape 30a. A plurality of positioning holes 30b1 are formed so as to penetrate the protection tape 31 in the rear face splicing tape 30b along the protection tape 31 in the width direction at the same pitch intervals as those of the sprocket holes Hc1 and Hc2 which are formed in the carrier tapes T1 and T2.

The feeding holes 31a and the positioning holes 31b formed in the protection tape 31 are formed through punching-pressing in association with forming of the positioning holes 30b1 performed in the splicing tape 30b after the splicing tapes 30a and 30b are pasted on the protection tape 31 at a predetermined position.

As illustrated in Fig. 8, in the splicing apparatus 20, the rotatable supply reel 33 around which the three-layer structure body including the splicing tape 30 is wound in a rolled manner, a paper mount feeding device 35 which feeds the paper mount 32 caused to peel off from the splicing tape 30, and a protection tape feeding device 36 which feeds the protection tape 31 from which the splicing tape 30 peels off are arranged on a line crossing the splicing position LS where the two carrier tapes T1 and T2 are spliced.

Regarding a glue force of the splicing tapes 30 with respect to the paper mount 32 and the protection tape 31 which are glued onto both faces of the splicing tapes 30, the glue force with respect to the protection tape 31 is stronger than the other. Therefore, even though the paper mount 32 is caused to peel off from the splicing tape 30, the splicing tape 30 is prevented from peeling off from the protection tape 31.

However, if the carrier tapes T1 and T2 are glued onto the glue face of the splicing tape 30 from which the paper mount 32 is peeled off, the adhesive force thereof is stronger than the adhesive force with respect to the protection tape 31. Therefore, the protection tape 31 is likely to peel off from the splicing tape 30.

The three-layer structure body including the paper mount 32, the splicing tape 30, and the protection tape 31 is mounted in the splicing apparatus 20 in a state of being wound around the supply reel 33, and the distal end thereof is drawn out from the supply reel 33. Then, a worker peels off and folds back the paper mount 32 to, and the paper mount 32 is fed by the paper mount feeding device 35 and is discarded into a paper mount accommodation box (not illustrated).

The protection tape 31 from which the paper mount 32 is peeled off, that is, the protection tape 31 in which multiple splicing tapes 30 are pasted with the glue face thereof facing upward passes through the below-described bonding device 58 so as to cross the center of the splicing position LS, and thus, the distal end portion of the protection tape 31 engages with a feeding sprocket 46 (refer to Fig. 12) of the protection tape feeding device 36.

As illustrated in Fig. 12, in the feeding sprocket 46, the protection tape 31 which engages with the engagement teeth 46a is fed by a unit quantity by forming a plurality of engagement teeth 46a at equiangular intervals in a circumferential direction at the same pitch as the pitch of the feeding holes 31a bored in the protection tape 31 and driving a stepping motor 47 connected to the feeding sprocket 46 by one pitch. The stepping motor 47 returns to the original position as power is supplied, and an engagement teeth 46a of the feeding sprocket 46 is positioned so as to be at the apex at all times.

As the protection tape 31 (the splicing tape 30) is fed by a unit quantity ΔPd as illustrated in Figs. 13 (A) to 13 (F) in accordance with the stepping motor 47 driven by one pitch and the feeding thereof is repeated N times (for example, 5 times), the protection tape 31 is fed by only the pitch Pd of one set of the splicing tapes 30, and thus, one set of the splicing tapes 30 for the front face and the rear face is sequentially conveyed to the splicing position LS.

As illustrated in Fig. 7, the splicing apparatus 20 includes the first and second tape feeding devices 50 and 51, first and second component detection devices 52 and 53, first and second cutting devices 54 and 55, first and second take-in devices 56 and 57, the bonding device 58, and a control device 59 (refer to Fig. 6). The first and second tape feeding devices 50 and 51, the first and second cutting devices 54 and 55, the first and second take-in devices 56 and 57, the bonding device 58 (excluding a portion thereof), and the control device 59 are accommodated and disposed inside the casing 21 covered with the lid body 22.

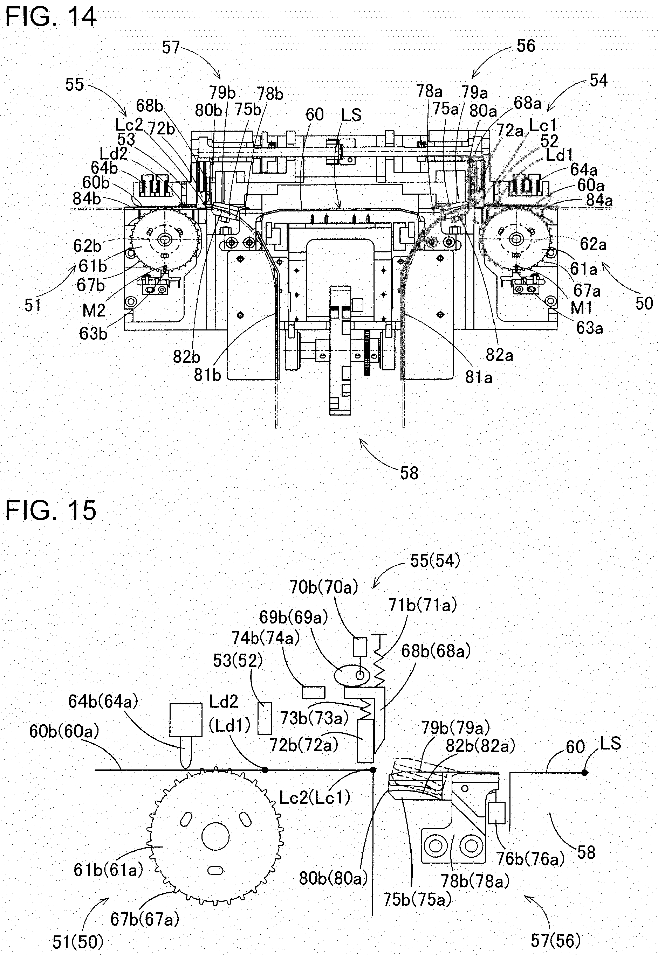

In other words, as illustrated in Fig. 14, the first and second tape feeding devices 50 and 51 are respectively disposed on both the sides in the casing 21 covered with the lid body 22. The first and second cutting devices 54 and 55 are respectively disposed between the first and second tape feeding devices 50 and 51. The first and second take-in devices 56 and 57 are respectively disposed between the first and second cutting devices 54 and 55. The bonding device 58 is disposed between the first and second take-in devices 56 and 57. The first and second component detection devices 52 and 53 are disposed above first and second detection positions Ld1 and Ld2 of first and second conveyance paths 60a and 60b in the first and second tape feeding devices 50 and 51.

The first and second tape feeding devices 50 and 51 include the first and second conveyance paths 60a and 60b which are provided so as to extend from both the side faces in the casing 21 toward the center in a horizontal direction, the first and second sprockets 61a and 61b which are disposed below the first and second conveyance paths 60a and 60b, first and second stepping motors 62a and 62b which are connected to the first and second sprockets 61a and 61b, first and second sprocket tooth detection devices 63a and 63b which are disposed in the vicinity of the first and second sprockets 61a and 61b, first and second tape detection devices 64a and 64b which are disposed above the first and second conveyance paths 60a and 60b, and the like.

The first and second tape feeding devices 50 and 51 are configured to convey the first and second carrier tapes T1 and T2 in the first and second conveyance paths 60a and 60b, and to be able to position the first and second cutting places Q1 and Q2 (refer to Fig. 4) of the first and second carrier tapes T1 and T2 sequentially at first and second cutting positions Lc1 and Lc2, and the splicing position LS.

The first and second conveyance paths 60a and 60b have widths slightly greater than the widths of the first and second carrier tapes T1 and T2, and are formed to have groove shapes extending in straight lines from first and second tape entrances 84a and 84b provided on both the side faces in the casing 21 to the first and second cutting positions Lc1 and Lc2 of the first and second carrier tapes T1 and T2 which are cut by first and second cutters 68a and 68b of the first and second cutting devices 54 and 55.

In addition, as illustrated in the enlarged view A in Fig. 7 (only the second conveyance path 60b is illustrated, but the first conveyance path 60a is the same as well), first and second micro grooves 65a and 65b for allowing the first and second cavities Cte1 and Cte2 of the first and second embossed tapes T1e and T2e having the first and second components e1 and e2 accommodated therein are formed in the first and second conveyance paths 60a and 60b.

In other words, first and second leaf springs 66a and 66b are fixedly disposed on the sides of the first and second cutting positions Lc1 and Lc2 of the first and second micro grooves 65a and 65b. The first and second leaf springs 66a and 66b are curved to have a concave shape and are fixedly disposed so as to incline obliquely upward and gradually toward the first and second cutting positions Lc1 and Lc2. The first and second leaf springs 66a and 66b are members which operate when the first and second embossed tapes T1e and T2e are cut and conveyed.

A plurality of the first and second teeth 67a and 67b are formed in the first and second sprockets 61a and 61b in the circumferential direction having the same pitch as the pitch Ph of the first and second sprocket holes Hc1 and Hc2 which are bored in the first and second carrier tapes T1 and T2. The first and second sprockets 61a and 61b are disposed below the first and second conveyance paths 60a and 60b so as to be able to mesh with the first and second sprocket holes Hc1 and Hc2 of the first and second conveyance paths 60a and 60b which are inserted along the first and second carrier tapes T1 and T2.

The first and second sprocket tooth detection devices 63a and 63b detect that the first and second sprockets 61a and 61b are at the original positions by reading first and second marks M1 and M2 applied on the side faces of the first and second sprockets 61a and 61b.

The first and second tape detection devices 64a and 64b detect that the first and second carrier tapes T1 and T2 are inserted from the first and second tape entrances 84a and 84b provided on both the side faces in the casing 21.

The first and second component detection devices 52 and 53 detect the first and second cavities Ct1 and Ct2 of the first and second carrier tapes T1 and T2 which are conveyed through the first and second conveyance paths 60a and 60b, a tape portion between the first and second cavities Ct1 and Ct2, and first and second components e1 and e2 inside the first and second cavities Ct1 and Ct2.

As illustrated in Figs. 14 and 15, the first and second cutting devices 54 and 55 include the first and second cutters 68a and 68b which are provided in the first and second cutting positions Lc1 and Lc2, first and second cams 69a and 69b which can come into sliding contact with the first and second cutters 68a and 68b, first and second gear motors 70a and 70b which are connectively in contact with the first and second cams 69a and 69b, first and second cutter springs 71a and 71b in which one end of each is attached to each of the first and second cutters 68a and 68b and the other end of each is attached to the inner side of the lid body 22, first and second pressing members 72a and 72b which are provided adjacent to the first and second cutters 68a and 68b, first and second pressing springs 73a and 73b in which one end of each is attached to each of the first and second cutters 68a and 68b and the other end of each is attached to each of the first and second pressing members 72a and 72b, first and second cutter detection devices 74a and 74b which are disposed in the vicinity of the first and second cutters 68a and 68b, and the like.

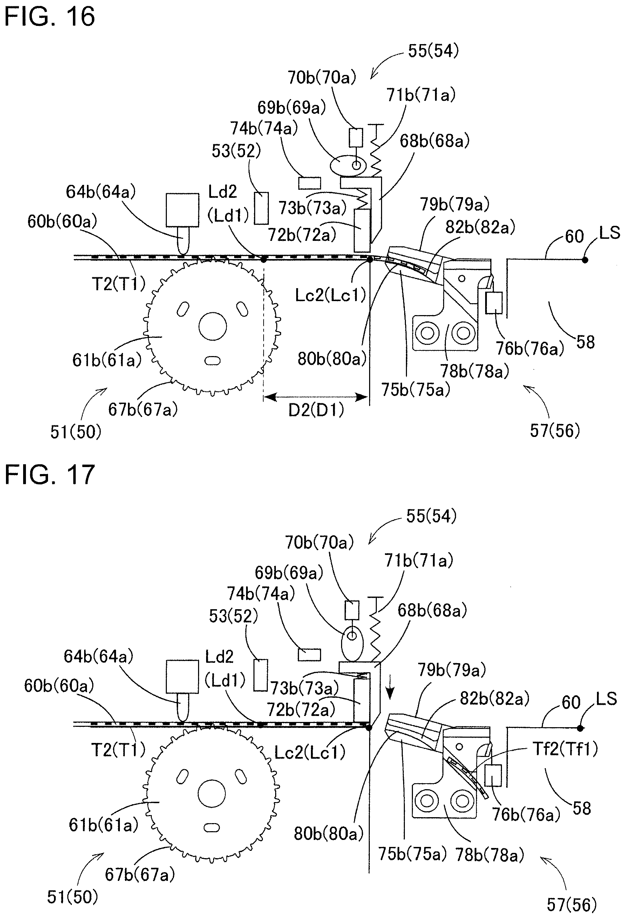

The first and second cutting devices 54 and 55 are configured to be able to cut the first and second unnecessary portions Tf1 and Tf2 (refer to Fig. 17) in the first and second cutting places Q1 and Q2 of the first and second carrier tapes T1 and T2.

In order to cut the first and second cutting places Q1 and Q2 of the first and second carrier tapes T1 and T2 which are positioned at the first and second cutting positions Lc1 and Lc2, the first and second cutters 68a and 68b are installed so as to be movable in a vertical direction, thereby moving in accordance with rotations of the first and second cams 69a and 69b.

In order to press and fix the vicinity of the first and second cutting places Q1 and Q2 of the first and second carrier tapes T1 and T2 which are positioned at the first and second cutting positions Lc1 and Lc2, the first and second pressing members 72a and 72b are provided so as to be movable in the vertical direction and are biased downward by the first and second pressing springs 73a and 73b.

The first and second take-in devices 56 and 57 are configured to include first and second take-in members 75a and 75b which are provided between the first and second cutting positions Lc1 and Lc2 and the splicing position LS and are turnably supported by first and second fixing members 78a and 78b, first and second take-in member turning devices 76a and 76b which turn the first and second take-in members 75a and 75b, and the like. The first and second take-in devices 56 and 57 are configured to be able to respectively take the cut first and second unnecessary portions Tf1 and Tf2 of the first and second carrier tapes T1 and T2.

First and second openings 80a and 80b for taking the first and second unnecessary portions Tf1 and Tf2 of the first and second carrier tapes T1 and T2 which are conveyed through the first and second conveyance paths 60a and 60b, and first and second ducts 82a and 82b for guiding the first and second unnecessary portions Tf1 and Tf2 to a dumping place (not illustrated) are formed in the first and second take-in members 75a and 75b.

While the first and second unnecessary portions Tf1 and Tf2 are taken in, the first and second take-in members 75a and 75b are retained at the original positions indicated by the dot-and-dash line in Fig. 15. When the first and second carrier tapes T1 and T2 are conveyed to the splicing position LS, as indicated by the solid line in Fig. 15, the first and second take-in member turning devices 76a and 76b turn the first and second take-in members 75a and 75b by a predetermined angle so as to cause first and second movable conveyance paths 79a and 79b formed in the first and second take-in members 75a and 75b to be aligned with the first and second conveyance paths 60a and 60b.

The bonding device 58 is provided between the first cutting device 54 and the second cutting device 55. The bonding device 58 is configured to be able to connect the first and second carrier tapes T1 and T2 to each other at the splicing position LS in the middle of the first and second conveyance paths 60a and 60b where the first and second cutting places Q1 and Q2 are caused to abut each other, by using the splicing tape 30.

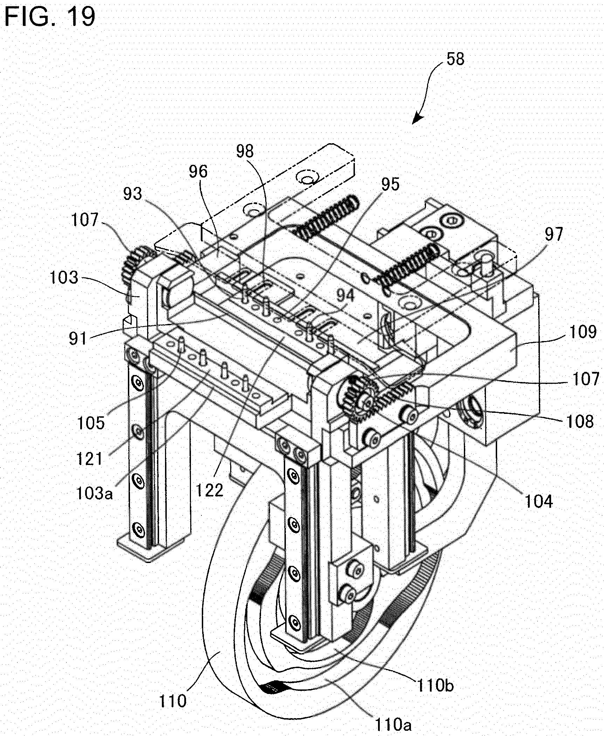

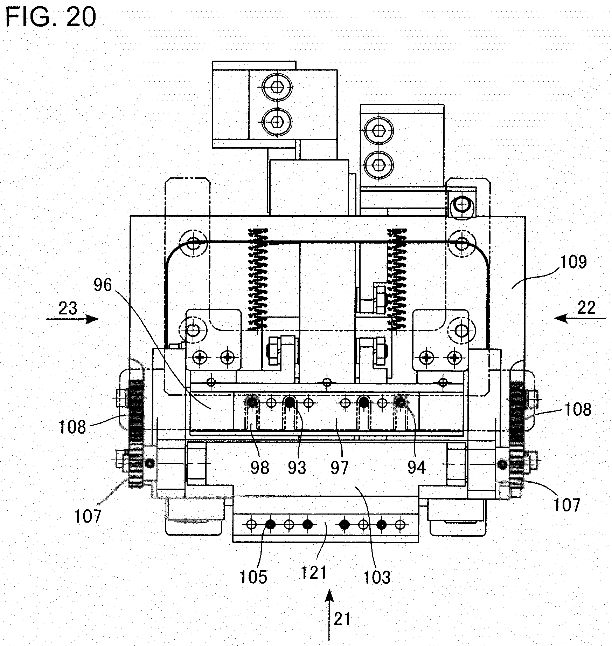

Subsequently, the configuration of the bonding device 58 will be described with reference to Figs. 19 to 23. The bonding device 58 includes a first lifting and lowering table 91, a pressing plate 97, a second lifting and lowering table 101, a swivel table 103, and the like. Leg portions 92 of the first lifting and lowering table 91 are guided and supported by the casing 21 so as to be able to be lifted and lowered. On the first lifting and lowering table 91, two for each of first positioning pins 93 and 94 which can engage with the positioning holes 30b1 formed in the splicing tape 30b, and each of the sprocket holes Hc of the two carrier tapes T1 and T2 are provided protruding along the carrier tapes T1 and T2 in a feeding direction on both the sides having a bonding position (an abutting position) of the two carrier tapes T1 and T2 as the center. Each pitch of the two sets of the first positioning pins 93 and 94 is set to be twice the pitch Ph of the sprocket holes Hc in the carrier tapes T1 and T2.

In the first lifting and lowering table 91, a pin hole 95 is formed between each set of the first positioning pins 93 and 94, and second positioning pins 105 on the below-described swivel table 103 side can be inserted into the pin holes 95.

A movable table 96 is movably guided and supported by the casing 21 in the horizontal direction orthogonal to the longitudinal direction of the carrier tapes T1 and T2. The pressing plate 97 is attached to the movable table 96 at a position above the first positioning pins 93 and 94. U-shaped grooves 98 which can accommodate the first positioning pins 93 and 94 are formed at the distal end of the pressing plate 97. The pressing plate 97 can move forward and rearward between positions of a rearward movement end at which the grooves 98 escape from the first positioning pins 93 and 94 and a forward movement end at which the grooves 98 accommodate the first positioning pins 93 and 94.

Moreover, leg portions 102 of the second lifting and lowering table 101 are guided and supported by the casing 21 so as to be able to be lifted and lowered. On the second lifting and lowering table 101, both ends of the swivel table 103 are supported having a pivot shaft 104 which is parallel to the longitudinal direction of the carrier tapes T1 and T2 as the swivel center, so as to be swivelable 180 degrees. A pressing plate 103a is provided in the swivel table 103 at a position offset from the swivel center. A plurality of the second positioning pins 105 and pin holes 106 are provided in the pressing plate 103a. Each of the second positioning pins 105 is arranged at a position corresponding to the middle of the first positioning pins 93 and 94 which are provided on the first lifting and lowering table 91, and is able to be inserted into the pin hole 95 which is provided in the first lifting and lowering table 91. Moreover, each of the pin holes 106 is arranged at a position corresponding to the middle of the second positioning pins 105, and the first positioning pins 93 and 94 which are provided on the first lifting and lowering table 91 can be inserted therein.

As the swivel table 103 swivels 180 degrees, the second positioning pins 105 engage with the sprocket holes Hc of the two carrier tapes T1 and T2 which are positioned at the splicing position LS and the positioning holes 30b1 of the splicing tape 30b so that positional relationships are regularly maintained among the three, that is, the two carrier tapes T1 and T2 and the splicing tape 30 which connects the two carrier tapes T1 and T2 to each other.

Pinions 107 are attached to the pivot shaft 104 of the swivel table 103, and racks 108 which mesh with the pinions 107 are attached to a movable table 109 which is movable in the horizontal direction orthogonal to a conveyance direction of the carrier tapes T1 and T2. Accordingly, as the movable table 109 moves, the swivel table 103 is caused to swivel by rack and pinion mechanisms each of which includes the pinion 107 and the rack 108.

As the swivel table 103 swivels, the three of the two carrier tapes T1 and T2 and the splicing tape 30 are pinched between the pressing plate 103a and the first lifting and lowering table 91, thereby being connected to one another.

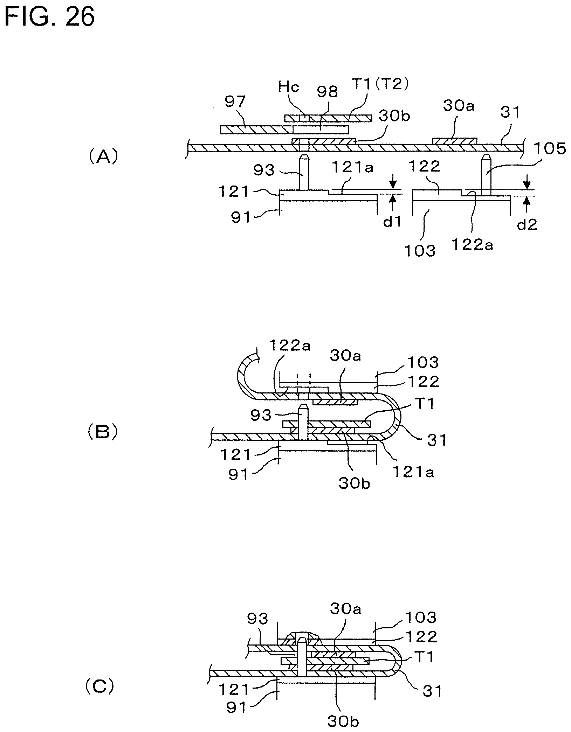

As illustrated in Fig. 19 and Fig. 26, sufficiently elastic rubber sheets 121 and 122 are respectively attached to the first lifting and lowering table 91 and the pressing plate 103a. The rubber sheets 121 and 122 are provided in order to precisely splice the carrier tape by using the splicing tape 30, regardless of whether the type of the carrier tape to be spliced is the paper tape or the embossed tape.

In other words, the rubber sheet 121 attached to the first lifting and lowering table 91 includes a step difference 121a which is formed by lowering a side provided with the cavities Ct1 and Ct2 with respect to a side provided with the sprocket holes Hc1 and Hc2 of the carrier tapes T1 and T2. In contrast, as illustrated in Fig. 26(B), the rubber sheet 122 attached to the pressing plate 103a includes a step difference 122a which is formed by raising a side provided with the cavities Ct1 and Ct2 with respect to a side provided with the sprocket holes Hc1 and Hc2. Then, as illustrated in Fig. 26(A), in step difference amounts d1 and d2 of both the rubber sheets 121 and 122, the rubber sheet 122 attached to the pressing plate 103a is caused to be greater than the other (d1 < d2).

The aforementioned configuration is made in order to reliably glue the splicing tape 30 onto the irregular face as well, since the embossed tape has the flat front face and the rear face which includes the irregularly protruding cavities Ct1 and Ct2, compared to the paper tape in which both the front face and the rear face are flat faces.

Accordingly, as described below, when the carrier tapes T1 and T2 (the paper tapes) are pinched by the first lifting and lowering table 91 and each of the rubber sheets 121 and 122 of the pressing plate 103a, the higher step difference portion of the rubber tape is deformed and the splicing tape 30 is bonded onto the carrier tapes T1 and T2. In contrast, when the carrier tapes T1 and T2 (the embossed tapes) are pinched by the first lifting and lowering table 91 and each of the rubber sheets of the pressing plate 103a, since the cavities Ct1 and Ct2 can be accommodated in the lower step difference portion of the rubber sheet 121 on the first lifting and lowering table 91, the splicing tape 30 can be bonded without adding excessive pressure to the cavities Ct1 and Ct2. Moreover, since the rubber sheet 122 attached to the pressing plate 103a is caused to be greater than the other regarding step difference between both the rubber sheets 121 and 122, when splicing the embossed tape, the rear face splicing tape can be reliably bonded onto the cavities Ct1 and Ct2 by pinching the cavities Ct1 and Ct2 with a greater elastic force (compression allowance).

A cam drum 110 is rotatably supported in the casing 21 around the axial line which is parallel to the swivel center of the swivel table 103, thereby rotating slowly in a regular direction by a drive motor (not illustrated). On both the faces of the cam drum 110, two sets of inner and outer cam grooves 110a and 110b, and 110c and 110d are respectively and endlessly formed in the circumferential direction.

A first follower roller (not illustrated) which is pivotally supported by the leg portions 92 of the first lifting and lowering table 91 engages with the first cam groove 110a. A second follower roller (not illustrated) which is pivotally supported by the movable table 96 connected to the pressing plate 97 engages with the second cam groove 110b. A third follower roller (not illustrated) which is pivotally supported by the leg portions 102 of the second lifting and lowering table 101 engages with the third cam groove 110c. A fourth follower roller (not illustrated) which is pivotally supported by a connection member 112 connected to the movable table 109 engages with the fourth cam groove 110d.

In this manner, as the cam drum 110 rotates, a lifting and lowering motion of each of the first and second lifting and lowering tables 91 and 101, a forward and rearward motion of the pressing plate 97, and a swivel motion of the swivel table 103 are inter-connectedly performed through the first to fourth follower rollers which respectively engage with the first to fourth cam grooves 110a to 110d. The first and second lifting and lowering tables 91 and 101, the pressing plate 97, and the swivel table 103 return to the original positions with one rotation of the cam drum 110.

As illustrated in Fig. 24, the splicing apparatus 20 is provided with a locking device 24 which locks the lid body 22 in a closed state during a splicing operation. The locking device 24 is mainly configured to include a solenoid 25 which is installed in the casing 21 and is able to actuate an actuation rod 25a in the vertical direction, a hook 27 which is turnably supported by the casing 21 centering around a pivot 26 and is caused to turn by the solenoid 25, and an engagement pin 28 which is provided in the lid body 22 so as to protrude downward and disengageably engages with the hook 27.

An opening spring 29 which biases the lid body 22 in an opening direction is provided between the casing 21 and the lid body 22. When the hook 27 is caused to disengage from the engagement pin 28, the lid body 22 is automatically moved by the opening spring 29 so as to uncover the inside. A dog (not illustrated) is provided in the lid body 22, and the casing 21 is provided with a closed-state confirmation sensor which is operated by the dog. The closed-state confirmation sensor is operated by the dog when covering the inside with the lid body 22, and a closed state of the lid body 22 is confirmed based on an ON signal of the closed-state confirmation sensor.

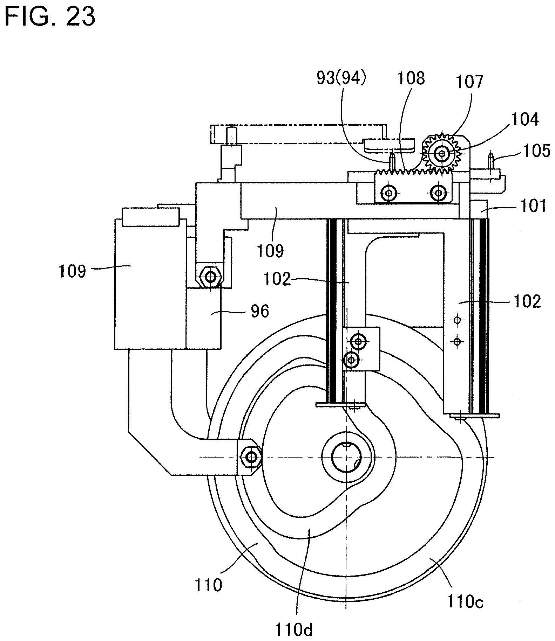

Then, when the lid body 22 is placed to cover the inside by a worker and the closed-state confirmation sensor is turned on by the dog, the actuation rod 25a of the solenoid 25 is actuated in the upward direction of Fig. 23 and the hook 27 is caused to turn so as to engage with the engagement pin 28, based on the ON signal. Accordingly, the lid body 22 is locked in a closed state by the locking device 24.

When the two carrier tapes T1 and T2 are connected to each other by the splicing tape 30 and a connection completion signal is issued by the control device 59, the actuation rod 25a of the solenoid 25 is actuated in the downward direction of Fig. 23. Accordingly, the hook 27 is caused to turn so as to disengage from the engagement pin 28, and the lid body 22 is automatically moved to uncover the inside due to a biasing force of the opening spring 29.

Subsequently, an operation of the splicing apparatus 20 according to the above-described embodiment will be described. When the remaining quantity of the components e retained in the first carrier tape T1 which is attached to the tape feeder 10 wound around the reel 12 decreases, splicing processing for causing the leading end portion of the second carrier tape T2 which is wound around another reel accommodating the same types of the components e to be connected to the trailing end portion of the first carrier tape T1 is executed by the splicing tape 30. The components can be reloaded through such splicing processing, and thus, the tape feeder 10 can continue to supply the components.

In such splicing processing, so-called verifying of splicing processing is generally executed in order to check whether or not the carrier tape accommodating the right components is connected thereto. In verifying of splicing processing, a barcode labelled on an old reel is read by a barcode reader, and the serial ID of the components accommodated in the old reel is transmitted to a management computer. Subsequently, a barcode labelled on a new reel is read by the barcode reader, and the serial ID of the components accommodated in the new reel is transmitted to the management computer.

Since data related to the component is stored in the database of the management computer for each serial ID, it is possible to verify whether or not the components accommodated in the two carrier tapes T1 and T2 are the same types by the read serial IDs. If the components are inconsistent with each other, a verification error is displayed on an operation panel and an operator is notified, and thus, the operator restarts splicing processing based thereon.

When verifying of splicing processing is completed, each end portion of the two carrier tapes T1 and T2 is cut with scissors. At this time, generally, since a vacant cavity portion having no component accommodated therein is provided at the end portion of each of the carrier tapes T1 and T2 to the extent of several tens of millimeters, the portion is cut by a worker. In this case, as is obvious from the following description, since the cut faces are not the abutting faces of the two carrier tapes T1 and T2, accuracy is not particularly required.

Generally, the lid body 22 is placed to cover the inside thereof. When a worker turns the power on in the state thereof, the control device 59 causes the stepping motors 62a and 62b to return to the original positions, based on detection signals from the first and second sprocket tooth detection devices 63a and 63b. In such a state, the control device 59 detects whether or not the distal end portions of the first and second tapes T1 and T2 are inserted from the first and second tape entrances 84a and 84b, based on detection signals from the first and second tape detection devices 64a and 64b. When it is detected that the distal end portions of the first and second tapes T1 and T2 are inserted, the stepping motors 62a and 62b start so as to rotate the first and second sprockets 61a and 61b, and cause movable members 77a and 77b of the first and second take-in members 75a and 75b to move upward.

Subsequently, the control device 59 sequentially detects the first vacant cavities Ct1 and Ct2, and the second vacant cavities Ct1 and Ct2 which do not include the components e1 and e2 in the first and second tapes T1 and T2, based on detection signals from the first and second tape detection devices 64a and 64b, thereby calculating the pitch Pc between the cavities Ct1 and Ct2 based on the detection of the first and second cavities Ct1 and Ct2.

Subsequently, the control device 59 calculates the cutting places Q1 and Q2 (refer to Fig. 4) of the first and second tapes T1 and T2 based on the pitch Pc between the cavities Ct1 and Ct2, and distances D1 and D2 between the known detection positions L d1 and L d2 and the known cutting positions Lc1 and Lc2. Then, as illustrated in Fig. 16, the first and second tapes T1 and T2 are moved by the distances D1 and D2, and the unnecessary portions Tf1 and Tf2 are taken in the first and second take-in members 75a and 75b, thereby conveying and positioning the cutting places Q1 and Q2 to the cutting positions Lc1 and Lc2.

In this manner, when conveying and positioning of the first and second carrier tapes T1 and T2 are completed, the control device 59 causes each of the cutters 68a and 68b to be lowered together with the pressing members 72a and 72b so as to press and fix the vicinity of the cutting places Q1 and Q2 of the first and second carrier tapes T1 and T2 which are positioned at the cutting positions Lc1 and Lc2, by using the pressing members 72a and 72b. Successively, each of the cutters 68a and 68b is lowered so as to cut each of the cutting places Q1 and Q2 of the first and second carrier tapes T1 and T2. The unnecessary portions Tf1 and Tf2 cut off from the first and second carrier tapes T1 and T2 are guided into the ducts 82a and 82b of the take-in members 75a and 75b, thereby being discarded.

As the first and second carrier tapes T1 and T2 are cut by the cutters 68a and 68b, the control device 59 causes the take-in members 75a and 75b to move downward. Thereafter, each of the sprockets 61a and 61b is caused to rotate by the stepping motors 62a and 62b, and the first and second carrier tapes T1 and T2 are moved respectively by the known distances D3 and D4 from the cutting positions Lc1 and Lc2 to the splicing position LS, thereby conveying and positioning the cutting places Q1 and Q2 of the first and second carrier tapes T1 and T2 at the splicing position LS. Accordingly, the sprocket holes Hc1 and Hc2 of the first and second carrier tapes T1 and T2 are positioned at positions so as to be able to engage with the first positioning pins 93 and 94 of the bonding device 58 provided at the splicing position LS.

The above-described first and second tape feeding devices 50 and 51 and the like configure a positioning device for positioning the first and second carrier tapes T1 and T2 at the splicing position LS where the positioning pins 93 and 94 respectively engage with the sprocket holes Hc1 and Hc2 of the first and second carrier tapes T1 and T2.

In this manner, the distal ends of the first and second carrier tapes T1 and T2 inserted from the first and second tape entrances 84a and 84b are positioned at the splicing position LS without causing a misaligned pitch.

Meanwhile, the three-layer structure body including the paper mount 32, the splicing tape 30, and the protection tape 31 wound around the supply reel 33 is drawn out from the supply reel 33, and the paper mount 32 is peeled off, thereby being fed by the paper mount feeding device 35. The protection tape 31 having the splicing tape 30 pasted thereto is fed by the protection tape feeding device 36, and thus, one set of the splicing tapes 30 for the front face and the rear face is conveyed to the splicing position LS.

In other words, as the stepping motor 47 of the protection tape feeding device 36 feeds the splicing tape 30 by the unit quantity ΔPd as illustrated in Fig. 13 and the feeding thereof is repeated N times (5 times in the embodiment), one set of the splicing tapes 30 for the front face and the rear face is fed by only the pitch Pd, thereby being conveyed to the splicing position LS, as illustrated in Fig. 13(F).

As one set of the splicing tapes 30 for the front face and the rear face is conveyed to the splicing position LS, one side of the successive one set of the splicing tapes 30, that is, the front face splicing tape 30a is detected by the first metal detection sensor 48, and at the same time, the rear face splicing tape 30b of the next successive one set of the splicing tapes 30 is detected by the second metal detection sensor 49. Accordingly, it is possible to confirm that the one set of the splicing tapes 30 for the front face and the rear face is properly positioned at the splicing position LS, and thus, it is possible to reliably prevent the front face splicing tape 30a and the rear face splicing tape 30b from being positioned at the splicing position LS in a reverse disposition.

In this manner, when the splicing tape 30 is positioned at the splicing position where the first and second metal detection sensors 48 and 49 are simultaneously turned on, the positioning is performed at a position where the positioning holes 30b1 formed in the rear face splicing tape 30b can engage with the first positioning pins 93 and 94 of the bonding device 58 provided at the splicing position LS (refer to Fig. 25). When the splicing tape 30 is positioned at the splicing position LS, if the first and second carrier tapes T1 and T2 are not positioned at the splicing position LS, the splicing tape 30 is on standby until the first and second carrier tapes T1 and T2 are positioned at the splicing position LS.

As each of the first and second carrier tapes T1 and T2, and the splicing tape 30 is positioned at the splicing position LS, the drive motor (not illustrated) rotates the cam drum 110. Firstly, in accordance with rotations of the cam drum 110, the first lifting and lowering table 91 rises through the first follower roller (not illustrated) which engages with the first cam groove 110a.

As the first lifting and lowering table 91 rises, the first positioning pins 93 and 94 respectively engage with the positioning holes 30b1 in the rear face splicing tape 30b and each of the sprocket holes Hc in the two carrier tapes T1 and T2. At this time, as illustrated in Fig. 26(A), since the pressing plate 97 is interposed between the rear face splicing tape 30b and each of the carrier tapes T1 and T2, the carrier tapes T1 and T2 are not glued onto the rear face splicing tape 30b. Accordingly, the positional relationships among the three, that is, the two carrier tapes T1 and T2 and the rear face splicing tape 30b which is glued onto the rear face sides of the two carrier tapes T1 and T2 can be regularly maintained.

Subsequently, the movable table 96 moves in the horizontal direction through the second follower roller (not illustrated) which engages with the second cam groove 110b. The pressing plate 97 which is interposed between the rear face splicing tape 30b and the carrier tapes T1 and T2 moves rearward with respect to the first lifting and lowering table 91. Thus, the rear face splicing tape 30b can be glued onto the carrier tapes T1 and T2.

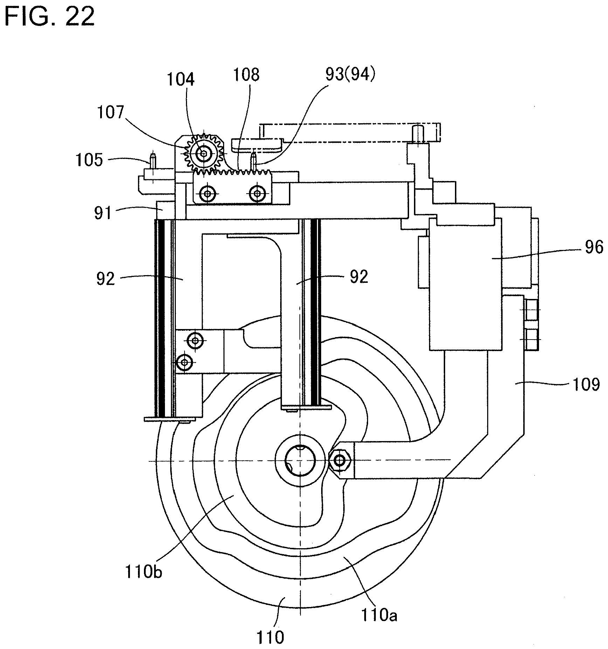

Subsequently, the movable table 109 moves horizontally through the third follower roller (not illustrated) which engages with the third cam groove 110c. In accordance with the horizontal movement of the movable table 109, the swivel table 103 swivels in the clockwise direction of Fig. 22 by the rack and pinion mechanism (107 and 108). In accordance with swiveling of the swivel table 103, as illustrated in Fig. 26(B), the protection tape 31 engaging with the second positioning pins 105 is bent, and the front face splicing tape 30a is turned over with the glue face facing downward at a position above the carrier tapes T1 and T2. In other words, the protection tape 31 is bent so as to clamp the carrier tapes T1 and T2 therebetween. Then, the rear face splicing tape 30b is positioned on the rear face sides of the carrier tapes T1 and T2, and the front face splicing tape 30a is positioned on the front face sides of the carrier tapes T1 and T2. At this time, the motor of the protection tape feeding device 36 rotates reversely so as to impart slackness to the protection tape 31, thereby allowing the protection tape 31 to be bent.

Successively, the second lifting and lowering table 101 is lowered through the fourth follower roller (not illustrated) which engages with the fourth cam groove 110d. As the second lifting and lowering table 101 is lowered, as illustrated in Fig. 26(C), the second positioning pins 105 engage with the positioning holes 31b of the protection tape 31, the sprocket holes Hc of the carrier tapes T1 and T2, and the positioning holes 30b1 of the rear face splicing tape 30b from the rear side of the protection tape 31.

Moreover, as the second lifting and lowering table 101 is lowered, in a state of pinching the carrier tapes T1 and T2, the bent protection tape 31 is pressed between the pressing plate 103a of the swivel table 103 and the first lifting and lowering table 91. Due to the pressing, the rear face splicing tape 30b pasted on the protection tape 31 is glued across the rear faces of the carrier tapes T1 and T2, and the front face splicing tape 30a is glued across each of the top tapes Tt which are pasted on the front faces of the carrier tapes T1 and T2. Thus, the trailing end portion of the first carrier tape T1 and the leading end portion of the second carrier tape T2 are connected to each other. The pressed state lasts for a certain time (for several seconds).

In this case, the pressing plate 103a and the first lifting and lowering table 91 are provided with the rubber sheets 121 and 122 which respectively include the step differences 121a and 122a. However, due to the pressing described above, the rubber sheets 121 and 122 are elastically deformed so as to be flat following after the front face and the rear face of the carrier tapes T1 and T2.

Since the two carrier tapes T1 and T2 are connected by the splicing tape 30 in a state where the carrier tapes T1 and T2 and the splicing tapes 30a and 30b are restricted in relative misalignment by the first and second positioning pins 93, 94, and 105, the two carrier tapes T1 and T2 can be accurately bonded without causing misalignment of the pitch.

Bonding of the two carrier tapes T1 and T2 performed by the splicing tape 30 is achieved in accordance with the 180-degree rotation of the cam drum 110, and each of the constituting members return to the original position in accordance with the remaining 180-degree rotation due to an operation opposite to that described above.

In other words, the second lifting and lowering table 101 rises first, and the swivel table 103 rises with respect to the first lifting and lowering table 91. Then, the pressed state of the bent protection tape 31 is released, and the second positioning pins 105 escape from the positioning holes 30b1 of the rear face splicing tape 30b and each of the sprocket holes Hc of the two carrier tapes T1 and T2. In this case, since the splicing tape 30 has high adhesiveness with respect to the carrier tapes T1 and T2, the protection tape 31 easily peels off from the splicing tape 30 due to a returning force of the spring of the protection tape 31 generated by releasing the pressed state of the protection tape 31, and thus, the splicing tape 30 is not peeled off from the carrier tapes T1 and T2.

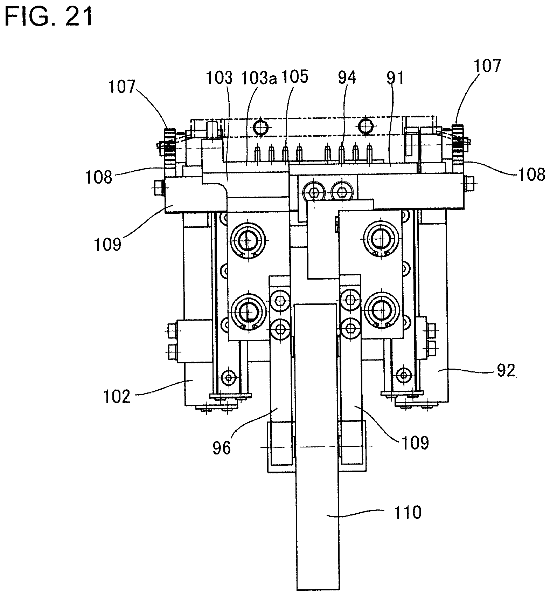

Successively, the swivel table 103 swivels in the counterclockwise direction of Fig. 21 through the rack and pinion mechanism (108 and 107), and the motor of the protection tape feeding device 36 rotates forward, thereby eliminating the slackness of the protection tape 31.

Thereafter, the pressing plate 97 moves forward, and the first lifting and lowering table 91 is lowered. Then, the first positioning pins 93 and 94 escape from the positioning holes 30b1 of the rear face splicing tape 30b and each of the sprocket holes Hc of the two carrier tapes T1 and T2. Meanwhile, the motor is driven in the paper mount feeding device 35 so as to apply tension to the paper mount 32, and thus, the paper mount 32 is peeled off as much as necessary. In this manner, bonding between the trailing end portion of the first carrier tape T1 and the leading end portion of the second carrier tape T2 is completed.

In this manner, as the two carrier tapes T1 and T2 are connected to each other by the splicing tape 30, a connection completion signal is issued by the control device 59. Based on the connection completion signal, the solenoid 25 of the splicing apparatus 20 is actuated, the actuation rod 25a moves downward, and the hook 27 turns in the clockwise direction of Fig. 24 centering around the pivot 26. Accordingly, the hook 27 and the engagement pin 28 are disengaged from each other, and the lid body 22 turns centering around the pivot 23 by the biasing force of the spring 29, thereby automatically uncovering the inside thereof. In such a state, the first and second spliced carrier tapes T1 and T2 are taken out from the splicing apparatus 20 by a worker.

Thereafter, the reel 12 having the second carrier tape T2 wound therearound is set to the tape feeder 10, thereby completing splicing processing. In this manner, the tape feeder 10 is reloaded with the components, and thus, mounting of the components can be continuously carried out in the component mounting machine without stopping the machine.

When the lid body 22 is placed to cover the inside by a worker in order to splice another carrier tape, the closed-state confirmation sensor (not illustrated) is turned on by the dog which is fixed onto the lid body 22. Based on the ON signal of the closed-state confirmation sensor, the solenoid 25 is actuated, and the actuation rod 25a moves upward. Accordingly, the hook 27 turns in the counterclockwise direction of Fig. 24 centering around the pivot 26, thereby engaging with the engagement pin 28 fixed onto the lid body 22. At the same time, an actuation confirmation sensor (not illustrated) is turned on by the dog (not illustrated) attached to the hook 27. As both the closed-state confirmation sensor and the actuation confirmation sensor are turned on, the splicing apparatus 20 can be automatically operated.

In this manner, when the lid body 22 is placed to cover the inside, the lid body 22 cannot be in an open state by an external force. Thus, it is possible to prevent the operation section inside the splicing apparatus 20 from being in contact with a worker during an automatic operation, and to ensure safety. In addition, when splicing is completed, the lid body 22 is automatically moved so as to uncover the inside. Thus, it is possible to enhance workability.

The splicing apparatus 20 is provided with an operation button (not illustrated) which unlocks the locked state in case of an emergency stop. An automatic operation is stopped by operating the operation button during the automatic operation of the splicing apparatus 20 so that the lid body 22 can be manually moved to uncover the inside. In this case, the automatic operation cannot be performed unless the lid body 22 is placed to cover the inside and locked again.

As described above, the stepping motor 47 feeds the splicing tape 30 N times by the unit quantity ΔPd as illustrated in Fig. 13, and the splicing tape 30 is positioned at the splicing position LS where the first and second metal detection sensors 48 and 49 are simultaneously turned on. Thus, the first and second carrier tapes T1 and T2 are automatically bonded to each other by the bonding device 58.

When the lid body 22 of the splicing apparatus 20 is placed to cover the inside and power is supplied, the stepping motor 47 returns to the original position (the engagement tooth 46a of the feeding sprocket 46 is positioned at the apex), and in such a state, the stepping motor 47 intermittently feeds the splicing tape 30 by the unit quantity ΔPd. Accordingly, even though the position of the stepping motor 47 is misaligned while the splicing apparatus 20 is halted, the first splicing tape 30 which is pasted on the forefront of the protection tape 31 can be accurately positioned at the splicing position where the first and second metal detection sensors 48 and 49 are simultaneously turned on.

When the first and second metal detection sensors 48 and 49 are not simultaneously turned on (only the first metal detection sensor 48 is turned on) even though the stepping motor 47 feeds the splicing tape 30 N times by the unit quantity ΔPd, a splicing tape disconnection signal is issued by the control device 59. In this manner, disconnection of the splicing tape 30 can be detected by the first and second metal detection sensors 48 and 49, and a worker is notified so as to prepare a new protection tape 31.

Then, when a new protection tape 31 is set to the splicing apparatus 20, as the stepping motor 47 intermittently feeds the splicing tape 30 by the unit quantity ΔPd, the first and second metal detection sensors 48 and 49 are simultaneously turned on. Subsequently, based on the first and second metal detection sensors 48 and 49 which are simultaneously turned on, it is possible to detect that the first splicing tape 30 which is pasted on the forefront of the protection tape 31 is positioned at the splicing position LS.

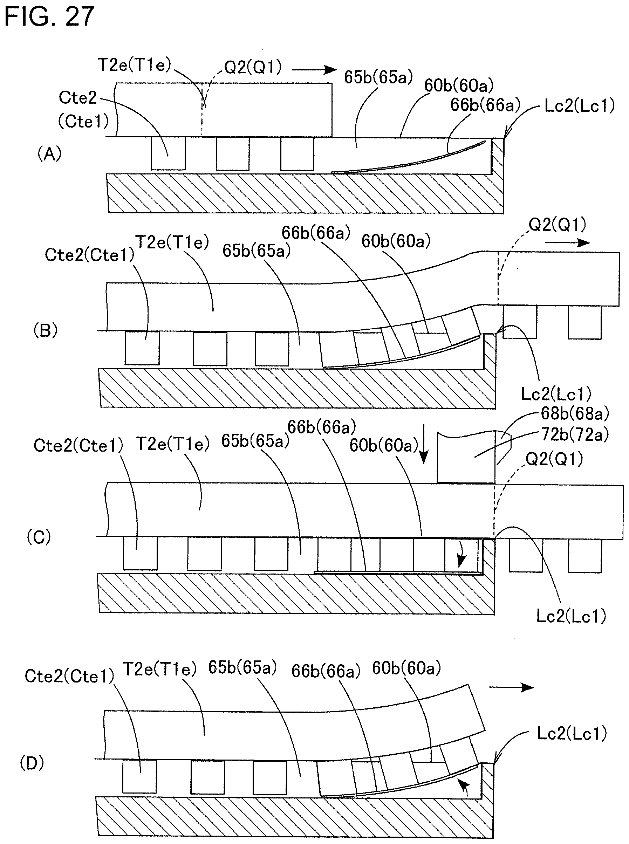

In the example described above, two of the carrier tapes T1 and T2 (paper tapes) having both the front face and the rear face to be flat are spliced. However, in a case where the first and second carrier tapes T1 and T2 are the embossed tapes T1e and T2e as illustrated in Fig. 5, when being conveyed along the first and second conveyance paths 60a and 60b, as illustrated in Fig. 27 (A), the first and second cavities Cte1 and Cte2 are conveyed along the inside of the first and second micro grooves 65a and 65b. Then, if the first and second embossed tapes T1e and T2e approach the first and second cutting positions Lc1 and Lc2, the first and second cavities Cte1 and Cte2 get on the first and second leaf springs 66a and 66b crossing over the first and second cutting positions Lc1 and Lc2, and thus, the first and second cutting places Q1 and Q2 are positioned at the first and second cutting positions Lc1 and Lc2 (refer to Fig. 27(B)).

Then, when the first and second cutters 68a and 68b are respectively lowered together with the first and second pressing members 72a and 72b, the first and second pressing members 72a and 72b press and fix the first and second cutting places Q1 and Q2 of the first and second embossed tapes T1e and T2e which are positioned at the first and second cutting positions Lc1 and Lc2. At this time, the first and second cavities Cte1 and Cte2 cause the first and second leaf springs 66a and 66b to be elastically deformed downward so as to be accommodated inside the first and second micro grooves 65a and 65b (refer to Fig. 27 (C)). Accordingly, the first and second cutting places Q1 and Q2 of the first and second embossed tapes T1e and T2e are positioned at the first and second cutting positions Lc1 and Lc2 with high accuracy, and thus, it is possible to enhance cutting accuracy of the first and second embossed tapes T1e and T2e.

Then, when the first and second cutters 68a and 68b respectively rise together with the first and second pressing members 72a and 72b, the first and second leaf springs 66a and 66b are restored and raise the first and second cavities Cte1 and Cte2 in the vicinity of the first and second cutting positions Lc1 and Lc2 upward from the first and second micro grooves 65a and 65b (refer to Fig. 27(D)). Accordingly, the first and second cavities Cte1 and Cte2 can get on the first and second leaf springs 66a and 66b crossing over the first and second cutting positions Lc1 and Lc2, and thus, the first and second embossed tapes T1e and T2e can be smoothly conveyed.

When the embossed tapes T1e and T2e are positioned at the splicing position LS, the cavities Cte1 and Cte2 of the embossed tapes T1e and T2e are accommodated at the lower step difference portion of the rubber sheet 121 which is attached to the first lifting and lowering table 91. Therefore, the splicing tapes 30a and 30b can be bonded onto the front face and the rear face of the embossed tapes T1e and T2e due to elastic forces of the rubber sheets 121 and 122 without adding an excessive force to the cavities Cte1 and Cte2.

Moreover, since a difference is provided between the step difference of the rubber sheet 121 which is attached to the first lifting and lowering table 91 and the step difference of the rubber sheet 122 which is attached to the pressing plate 103a (d1 < d2), when the embossed tapes T1e and T2e are pinched between the rubber sheets 121 and 122, a side provided with the cavities Cte1 and Cte2 is pinched by a greater elastic force compared to a side provided with the sprocket holes Hc1 and Hc2. Accordingly, the splicing tape 30 can be reliably bonded onto such embossed tapes T1e and T2e having irregularities.

According to the above-described embodiment, the embodiment includes the first and second tape feeding devices (the positioning devices) 50 and 51 that feed the first and second carrier tapes T1 and T2 in a direction approaching each other and cause the positioning pins 93 and 94 to be positioned at the splicing position LS so as to be able to engage with the sprocket holes Hc1 and Hc2 of the first and second carrier tapes T1 and T2, the plurality of a set of the splicing tapes 30 (30a and 30b) for the front face and the rear face that is pasted at the splicing position LS on the continuous protection tape 31 fed in a direction orthogonal to the feeding direction of the first and second carrier tapes T1 and T2 and has metal embedded therein, a pair of the metal detection sensors 48 and 49 that is disposed at an interval in the feeding direction of the protection tape 31 and detects the splicing tape 30, and the bonding device 58 that bonds the splicing tapes 30a and 30b fed to the splicing position LS on both faces across the first and second carrier tapes T1 and T2. The splicing tapes 30a and 30b are regularly arranged at intervals in the longitudinal direction of the protection tape 31, and the pair of the metal detection sensors 48 and 49 is configured to be simultaneously turned on only when one set of the splicing tapes 30a and 30b is positioned at the splicing position LS.

According to the above-described configuration, it is possible to easily detect that the one set of the splicing tapes 30a and 30b for the front face and the rear face is positioned at the splicing position LS as the pair of the metal detection sensors 48 and 49 is simultaneously turned on. Therefore, the splicing tapes 30a and 30b can be accurately positioned at the splicing position LS so as not to cause the front face splicing tape 30a and the rear face splicing tape 30b to be reversely disposed, and thus, it is possible to acquire the splicing apparatus 20 which can perform highly accurate splicing.

According to the above-described configuration, as the protection tape 31 is fed N times by the unit quantity in accordance with rotations of the sprocket 46 which engages with the feeding holes 31a formed at both ends of the protection tape 31 in the width direction, the splicing tapes 30a and 30b for the front face and the rear face are positioned at positions where the metal detection sensors 48 and 49 are simultaneously turned on. Therefore, feeding accuracy of the protection tape 31 can be enhanced based on a rotation amount of the sprocket 46, and the splicing tapes 30a and 30b can be accurately positioned at the splicing position LS regardless of slackness and the like of the protection tape 31.

According to the above-described configuration, since the rubber sheets 121 and 122 having a step difference are respectively provided in the lifting and lowering table 91 and the pressing plate 103a in which the first and second carrier tapes T1 and T2 and the splicing tapes 30a and 30b are pinched and the splicing tapes 30a and 30b are bonded onto the front face and the rear face of the first and second carrier tapes T1 and T2, even though the first and second carrier tapes T1 and T2 have irregularity similar to the embossed tapes T1e and T2e, the splicing tapes 30a and 30b can be reliably bonded onto the front face and the rear face of the embossed tapes T1e and T2e due to an elastic force of the rubber sheet 121 without adding an excessive force to the cavities Cte1 and Cte2 of the embossed tapes T1e and T2e.

Moreover, even though both the front face and the rear face of the first and second carrier tapes T1 and T2 are flat as those of the paper tape, the rubber sheets 121 and 122 are elastically deformed. Therefore, the step difference in the rubber sheets 121 and 122 causes no difficulty.

According to the above-described configuration, the lid body 22 is locked by the locking device 24 so that the lid body 22 cannot be in an open state by an external force. Therefore, it is possible to prevent the operation section inside the splicing apparatus 20 from being in contact with a worker during an automatic operation, and to ensure safety. In addition, when splicing is completed, the lid body 22 can be automatically moved so as to uncover the inside. Thus, it is possible to enhance workability.

According to the above-described embodiment, descriptions are given regarding an example in which metal is embedded in the splicing tapes 30a and 30b, and the splicing tapes 30a and 30b are detected by the metal detection sensors 48 and 49. However, the splicing tape can be detected by a method other than the method of detecting metal.

According to the above-described embodiment, descriptions are given regarding the three-layer structure body including the splicing tape 30, the protection tape 31, and the paper mount 32. However, it is possible to configure a two-layer structure body including the splicing tape 30 and the protection tape 31, omitting the paper mount 32.

Moreover, the positioning devices (the first and second tape feeding devices) 50 and 51 for positioning the first and second carrier tapes T1 and T2 at the splicing position LS, the protection tape feeding device 36 for feeding the protection tape 31 in which the splicing tapes 30a and 30b are pasted, the bonding device 58 for bonding the splicing tapes 30a and 30b onto the first and second carrier tapes T1 and T2 at the splicing position LS, and the like are only exemplified configurations which are suitable for executing the present invention. The present invention is not limited to the configuration described in the embodiment.

As described above, the present invention can be applied with various forms without departing from the scope of the present invention disclosed in Claims.

### Reference Signs List

20 ... splicing apparatus; 21 ... casing; 22 ... lid body; 24 ... locking device; 30 (30a, 30b) ... splicing tape; 31 ... protection tape; 31a ... feeding hole; 36 ... protection tape feeding device; 46 ... sprocket; 47 ... stepping motor; 48, 49 ... sensor (metal detection sensor) ; 50, 51 ... positioning device (tape feeding device); 58 ... bonding device; 93, 94, 105 ... positioning pin; T1, T2 ... carrier tape; Hc1, Hc2 ... sprocket hole; Ct1, Ct2 ... cavity; LS ... splicing position.

## Claims

1. A splicing apparatus (20) in which a first carrier tape (T1) and a second carrier tape (T2) provided with sprocket holes (Hc1, Hc2) and component accommodation cavities (Ct) at regular intervals are connected to each other by a splicing tape (30), the apparatus comprising:
a positioning device (50, 51) that feeds the first and second carrier tapes (T1, T2) in a direction approaching each other and causes positioning pins (93, 94, 105) to be positioned at a splicing position (LS) so as to be able to engage with the sprocket holes (Hc1, Hc2) of the first and second carrier tapes (T1,T2);
a plurality of the splicing tapes (30a, 30b) that are pasted at the splicing position (LS) on a continuous protection tape (31) fed in a direction orthogonal to a feeding direction of the first and second carrier tapes (T1, T2) and form one set with a front face splicing tape (30a) for connecting a front face side of the carrier tape (T1) and a rear face splicing tape (30b) for connecting a rear face side of the carrier tape (T2);
a pair of sensors (48, 49) that is disposed at an interval in the feeding direction of the protection tape (31) and detects the splicing tapes (30a, 30b); and
a bonding device (58) that bonds the splicing tapes (30a, 30b) fed to the splicing position (LS) onto both faces across the first and second carrier tapes (T1, T2),
wherein the splicing tapes (30a, 30b) are regularly arranged at intervals in a longitudinal direction of the protection tape (31), and
wherein the pair of sensors (48, 49) is configured to be simultaneously turned on only when the one set of the splicing tapes (30a, 30b) is positioned at the splicing position (LS).

2. The splicing apparatus according to Claim 1,
wherein metal is embedded in the splicing tape (30) and the sensor (48, 49) is formed to be a metal detection sensor which detects metal.

3. The splicing apparatus according to Claim 1 or 2,
wherein the one set of the splicing tapes (30a, 30b) is positioned at positions where the pair of sensors (48, 49) is simultaneously turned on by forming feeding holes (31a) at both ends of the protection tape (31) in a width direction and rotating a sprocket (46) which engages with the holes (31a) so as to feed the protection tape (31) N times by a unit quantity.

4. A method of detecting a splicing tape (30) that is used in a splicing apparatus (20) in which a first carrier tape (T1) and a second carrier tape (T2) provided with sprocket holes (Hc1, Hc2) and component accommodation cavities (Ct) at regular intervals are connected to each other by the splicing tape (30),
wherein one set of the splicing tapes (30a, 30b) for a front face and a rear face which is glued onto both faces across the first and second carrier tapes (T1, T2) positioned at a splicing position (LS) are pasted on a protection tape (31), and
wherein a pair of sensors (48, 49) which is disposed at intervals in a feeding direction of the protection tape (31) is simultaneously turned on only when the one set of the splicing tapes (30a, 30b) is positioned at the splicing position (LS).

## Patentansprüche

1. Verklebe-Vorrichtung (20), in der ein erstes Trägerband (T1) und ein zweites Trägerband (T2), die mit Führungslöchern (Hc1, Hc2) und Bauteil-Aufnahmevertiefungen (Ct) in gleichmäßigen Abständen versehen sind, mittels eines Klebebandes (30) miteinander verbunden werden, wobei die Vorrichtung umfasst:
eine Positionier-Einrichtung (50, 51), die das erste und das zweite Trägerband (T1, T2) in einer Richtung zuführt, in der sie sich einander nähern, und bewirkt, dass Positionierstifte (93, 94, 105) an einer Verklebe-Position (LS) so platziert werden, dass sie mit den Führungslöchern (Hc1, Hc2) des ersten und des zweiten Trägerbandes (T1, T2) in Eingriff kommen können;
eine Vielzahl der Klebebänder (30a, 30b), die an der Verklebe-Position (LS) an ein Endlos-Schutzband (31) angeklebt werden, das in einer Richtung im rechten Winkel zu einer Zuführrichtung des ersten und des zweiten Trägerbandes (T1, T2) zugeführt wird, und die eine Gruppe mit einem Vorderseiten-Klebeband (30a) zum Verbinden einer Vorderseite des Trägerbandes (T1) sowie einem Rückseiten-Klebeband (30b) zum Verbinden einer Rückseite des Trägerbandes (T2) bilden;
paarige Sensoren (48, 49), die in einem Abstand in der Zuführrichtung des Schutzbandes (31) angeordnet sind und die Klebebänder (30a, 30b) erfassen; sowie
eine Aufklebe-Einrichtung (58), die die der Verklebe-Position (LS) zugeführten Klebebänder (30a, 30b) auf beide Flächen über das erste und das zweite Trägerband (T1, T2) aufklebt,
wobei die Klebebänder (30a, 30b) in gleichmäßigen Abständen in einer Längsrichtung des Schutzbandes (31) angeordnet sind, und
die paarigen Sensoren (48, 49) so ausgeführt sind, dass sie gleichzeitig nur dann angeschaltet werden, wenn die eine Gruppe der Klebebänder (30a, 30b) an der Verklebe-Position (LS) platziert ist.

2. Verklebe-Vorrichtung nach Anspruch 1,
wobei Metall in das Klebeband (30) eingebettet ist und der Sensor (48, 49) so ausgebildet ist, dass er ein Metallerfassungs-Sensor ist, der Metall erfasst.

3. Verklebe-Vorrichtung nach Anspruch 1 oder 2,
wobei die eine Gruppe der Klebebänder (30a, 30b) an Positionen platziert ist, an denen die paarigen Sensoren (48, 49) gleichzeitig angeschaltet werden, indem Transportlöcher (31 a) an beiden Enden des Schutzbandes (31) in einer Breitenrichtung ausgebildet werden und ein Transportrad (46) gedreht wird, das mit den Löchern (31 a) in Eingriff ist, um das Schutzband (31) N mal um eine Größeneinheit zuzuführen.

4. Verfahren zum Erfassen eines Klebebandes (30), das in einer Verklebe-Vorrichtung (20) eingesetzt wird, in der ein erstes Trägerband (T1) und ein zweites Trägerband (T2), die mit Führungslöchern (Hc1, Hc2) und Bauteil-Aufnahmevertiefungen (Ct) in gleichmäßigen Abständen versehen sind, mittels eines Klebebandes (30) miteinander verbunden werden,
wobei eine Gruppe der Klebebänder (30a, 30b) für eine Vorderseite und eine Rückseite, die auf beide Flächen über das erste und das zweite Trägerband (T1, T2) aufgeleimt ist, die an einer Verklebe-Position (LS) positioniert sind, an ein Schutzband (31) angeklebt werden, und
paarige Sensoren (48, 49), die in Abständen in einer Zuführrichtung des Schutzbandes (31) angeordnet sind, gleichzeitig nur dann angeschaltet werden, wenn die eine Gruppe der Klebebänder (30a, 30b) an der Verklebe-Position (LS) platziert ist.

## Revendications

1. Dispositif de raccordement (20) dans lequel un premier ruban porteur (T1) et un second ruban porteur (T2) dotés, à intervalles réguliers, de perforations d'entraînement (Hc1, Hc2) et de cavités de réception de composant (Ct) sont raccordés l'un à l'autre par un ruban de raccordement (30), le dispositif comprenant :
un dispositif de positionnement (50, 51) qui achemine les premier et second rubans porteurs (T1, T2) dans une direction les rapprochant l'un de l'autre et qui entraîne le positionnement des broches de positionnement (93, 94, 105) au niveau de la position de raccordement (LS) de manière à ce qu'elles puissent interagir avec les perforations d'entraînement (Hc1, Hc2) des premier et second rubans porteurs (T1, T2) ;
une pluralité de rubans de raccordement (30a, 30b) qui sont collés au niveau de la position de raccordement (LS) sur un ruban protecteur continu (31) acheminé dans une direction orthogonale à une direction d'acheminement des premier et second rubans porteurs (T1, T2) et qui forment un ensemble qui présente un ruban de raccordement de face avant (30a) pour raccorder un côté face avant du ruban porteur (T1) et un ruban de raccordement de face arrière (30b) pour raccorder un côté face arrière du ruban porteur (T2) ;
une paire de capteurs (48, 49) qui est disposée en laissant un intervalle dans la direction d'acheminement du ruban protecteur (31) et détectant les rubans de raccordement (30a, 30b) ; et
un dispositif de liaison (58) qui lie les rubans de raccordement (30a, 30b) acheminés vers la position de raccordement (LS) aux deux faces des premier et second rubans porteurs (T1, T2),
où les rubans de raccordement (30a, 30b) sont agencés à intervalles réguliers dans la direction longitudinale du ruban protecteur (31), et
où la paire de capteurs (48, 49) est configurée pour être simultanément mise en marche, uniquement lorsque l'unique ensemble de rubans de raccordement (30a, 30b) est positionné au niveau de la position de raccordement (LS).

2. Dispositif de raccordement selon la revendication 1,
où du métal est incorporé dans le ruban de raccordement (30) et le capteur (48, 49) est formé de manière à être un capteur de détection de métal qui détecte du métal.

3. Dispositif de raccordement selon la revendication 1 ou 2,
où l'unique ensemble de rubans de raccordement (30a, 30b) est positionné à des positions où la paire de capteurs (48, 49) est simultanément mise en marche par la formation de trous d'acheminement (31a) aux deux extrémités du ruban protecteur (31) dans une direction de la largeur et la rotation d'un pignon (46) qui interagit avec les trous (31a) de manière à acheminer le ruban protecteur (31) N fois d'une unité de quantité.

4. Procédé de détection d'un ruban de raccordement (30) qui est utilisé dans un dispositif de raccordement (30) dans lequel un premier ruban porteur (T1) et un second ruban porteur (T2) dotés, à intervalles réguliers, de perforations d'entraînement (Hc1, Hc2) et de cavités de réception de composant (Ct) sont raccordés l'un à l'autre par le ruban de raccordement (30),
où un ensemble de rubans de raccordement (30a, 30b) pour une face avant et une face arrière qui est collé sur les deux faces en travers des premier et second rubans porteurs (T1, T2) positionnés au niveau d'une position de raccordement (LS) est collés au ruban protecteur (31), et
où une paire de capteurs (48, 49) qui est disposée en laissant un intervalle dans la direction d'acheminement du ruban protecteur (31) est simultanément mise en marche, uniquement lorsque l'unique ensemble de rubans de raccordement (30a, 30b) est positionné au niveau de la position de raccordement (LS).
